# EUROPÄISCHE PATENTSCHRIFT

(11) **EP 1 198 002 B1**
(45) Veröffentlichungstag und Bekanntmachung des Hinweises auf die Patenterteilung: **15.04.2009**
(21) Anmeldenummer: 01122430.0
(22) Anmeldetag: 20.09.2001
(51) Int. Cl.: H01L 23/13, H01L 23/053, H01L 23/057, H01L 23/14

(54) **Elektrisches oder elektronisches Bauteil und Verfahren zum Herstellen desselben**
Electric or Electronic Component and Method of Manufacturing the Same
Composant électrique ou électronique et sa méthode de fabrication

(30) Priorität: 23.09.2000 DE 10047213
(43) Veröffentlichungstag der Anmeldung: 17.04.2002
(73) Patentinhaber: NXP B.V., 5656 AG Eindhoven (NL)
(72) Erfinder: Steffens, Engelbert, 52064 Aachen (DE)
(74) Vertreter: van der Veer, Johannis Leendert

(56) Entgegenhaltungen:
- WO-A-01/24259
- WO-A-98/49653
- FR-A- 2 777 675
- US-A- 5 188 984
- US-A- 5 647 122
- US-A- 6 013 948

## Beschreibung

Die Erfindung betrifft ein elektrisches oder elektronisches Bauteil, aufweisend ein Trägersubstrat aus halbleitendem oder isolierendem Material
mindestens eine im Trägersubstrat vorgesehene Ausnehmung, insbesondere Kavität oder Vertiefung;
mindestens ein in der Ausnehmung implantiertes Bauelement, dessen mindestens eine elektrisch leitende Kontaktfläche aufweisende Oberfläche dem Boden- und/oder
Wandbereich der Ausnehmung zugewandt ist und im Boden- und/oder Wandbereich der Ausnehmung kontaktiert ist; und
mindestens ein Füllmaterial, mittels dessen das in der Ausnehmung implantierte Bauelement insbesondere mit den Rändern der Ausnehmung versiegelt ist.

Die Erfindung betrifft des weiteren ein Verfahren zum Herstellen eines elektrischen oder elektronischen Bauteils, aufweisend die folgenden Schritte:
Erzeugen, insbesondere Ätzen, von mindestens einer Ausnehmung, insbesondere von mindestens einer Kavität oder Vertiefung, in einem Trägersubstrat aus halbleitendem oder isolierendem Material;
Implantieren von mindestens einem Bauelement, insbesondere von mindestens einem IC-Chip und/oder von mindestens einem elektrisch aktiven oder elektronisch aktiven (Halbleiter-)Kristall, in der Ausnehmung, wobei die mindestens eine elektrisch leitende Kontaktfläche aufweisende Oberfläche des Bauelements dem Boden- und/oder Wandbereich der Ausnehmung zugewandt ist und im Boden- und/oder Wandbereich der Ausnehmung kontaktiert wird; und
Versiegeln des in der Ausnehmung implantierten Bauelements insbesondere mit den Rändern der Ausnehmung mittels mindestens eines Füllmaterials.

Solche Bauteile sowie Verfahren sind durch die Druckschriften DE 197 20 300 A1, FR 2,777,675, US 5,647,122 und US 5,188,984 bekannt. Dort ist ein elektronisches Hybrid-Bauteil mit koplanarer Chip-On-Chip-Anordnung und mit elektrischer Rückseitenkontaktierung offenbart; in einem (Silizium-) Trägersubstrat des Bauteils ist mindestens eine Kavität eingearbeitet, in der sich eine elektrische Isolationsschicht mit einer darüber angeordneten Metallschicht befindet und in der mindestens ein auf dem Trägersubstrat angeordneter Chip implantiert sowie mit der Metallschicht elektrisch kontaktiert ist.

Das aus der Druckschrift DE 197 20 300 A1 bekannte Verfahren zum Herstellen dieses Bauteils gestattet die Verwendung der in der Mikroelektronik und in der Mikrosystemtechnik üblichen Verfahrenstechniken und basiert im speziellen darauf, dass im Trägersubstrat durch anisotrope Ätzung abgesenkte Gebiete erzeugt werden und dass die Strukturierung zur Erzeugung der elektrisch leitenden Verbindung zwischen den abgcsenkten Gebieten und den auf der koplanaren Fläche befindlichen Leiterbahnstrukturen durch ein Mehrfach-Metallisierungssystem erfolgt; bei diesem Mehrfach-Metallisierungssystem erfolgt im Anschluss an das Ätzen eine Isolierung der abgesenkten Strukturen durch Oxidation oder durch Abscheiden von Isolatorschichten auf das Trägersubstrat; danach wird eine Metallisierung der abgesenkten Gebiete und des Trägersubstrats vorgenommen; dann wird eine Strukturierung der Mehrfach-Metallschicht innerhalb eines photolithographischen Prozesses unter Einhaltung bestimmter minimaler Strukturbreiten hergestellt.

Dieses bekannte Verfahren impliziert zwar eine Reihe von Vorteilen wie etwa die Herstellung kompakter elektronischer Bauteile mit äußerst geringen Abmessungen (geringe Bauhöhe; geringe Grundfläche, das heißt kleiner "footprint") des Gehäuses ("package") sowie mit ähnlichen oder sogar gleichen thermischen Eigenschaften von Chip und Gehäuse aufgrund Materialähnlichkeit oder sogar Materialidentität; auch entfallen beim konventionellen Verfahren kostspielige und störanfällige Herstellungsschritte wie etwa Wirebond-, Umhüllungs- und/oder Platingprozesse sowie der Materialeinsatz für Leadframes und Wires. Jedoch erweisen sich das bekannte Bauteil sowie das bekannte Verfahren zum Herstellen desselben insofern als unzureichend, als schon bei geringfügigen Verkippungen und/oder Schräglagen des Chips in der Ausnehmung des Trägersubstrats eine ordnungsgemäße Funktion des Bauteils nicht mehr gewährleistet ist, beispielsweise weil die elektrische Kontaktierung des Chips mit dem Inneren (Boden- und/oder Wandbereich) der Ausnehmung nicht mehr vollständig gegeben ist.

Dies bedeutet für die bekannten Bauteile nicht zuletzt, dass bei der Erzeugung der Ausnehmung im Trägersubstrat, etwa durch anisotropes Ätzen, im Grunde genommen keinerlei Toleranzen zulässig sind, was die Herstellung der aus der Druckschrift DE 197 20 300 A1 bekannten Bauteile sehr kostspielig macht und zu einer hohen Ausschussrate führt.

Der Erfindung liegt die Aufgabe zugrunde, ein elektrisches oder elektronisches Bauteil der eingangs genannten Art sowie ein Verfahren zum Herstellen desselben bereitzustellen, bei denen im Vergleich zum Stand der Technik größere Toleranzen in der Lage und insbesondere in der Verkippung des in der Ausnehmung implantierten Bauelements zugelassen werden können, ohne dass dies der elektrischen Kontaktierung des Bauelements mit dem Inneren (Boden- und/oder Wandbereich) der Ausnehmung zum Nachteil gereicht. In diesem Zusammenhang zielt die vorliegende Erfindung auch auf die Zulässigkeit größerer Toleranzen bei der Erzeugung der Ausnehmung im Trägersubstrat ab.

Diese Aufgabe wird durch die im Anspruch 1 für ein elektrisches oder elektronisches Bauteil angegebenen Merkmale sowie durch die im Anspruch 12 für ein Verfahren zum Herstellen eines elektrischen oder elektronischen Bauteils angegebenen Merkmale gelöst. Vorteilhafte Ausgestaltungen und zweckmäßige Weiterbildungen der vorliegenden Erfindung sind in den jeweiligen Unteransprüchen gekennzeichnet.

Gemäß der Lehre der vorliegenden Erfindung ist mindestens eine vom Boden- und/oder Wandbereich der Ausnehmung auf die Oberfläche des Trägersubstrats führende, elektrisch leitende Kontaktbahn vorgesehen, die vor Implantieren des Bauelements aufgebracht, insbesondere lithographisch aufgebracht, wird. Um nun eine zuverlässige Verbindung zwischen der jeweiligen Kontaktfläche des Bauelements und dem jeweiligen, sich im Boden- und/oder Wandbereich der Ausnehmung befindlichen Abschnitt der Kontaktbahn zu gewährleisten, ist in diesem Zwischenraum mindestens ein elektrisch leitendes Verbindungselement angeordnet, durch das die Kontaktfläche des Bauelements mit dem sich im Boden- und/oder Wandbereich der Ausnehmung befindlichen Abschnitt der Kontaktbahn verbunden ist.

Das Vorsehen derartiger Verbindungselemente hat den Vorteil, dass diese eine gewisse Verkippung des in der Ausnehmung implantierten Bauelements erlauben, ohne dass die elektrische Kontaktierung des Bauelements mit dem Inneren (Boden- und/oder Wandbereich) der Ausnehmung darunter leidet. Hierbei kann (, muss jedoch nicht) eine Verformung zumindest eines Teils der Verbindungselemente erfolgen, wodurch auf überraschende Weise ein Freiheitsgrad hinsichtlich der Position in der Tiefe und Verkippung des Bauelements gebildet ist. Des weiteren wird der Fachmann zu schätzen wissen, dass die Toleranzen bei der Herstellung der Ausnehmung, in der das Bauelement implantiert wird, wesentlich großzügiger als bei konventionellen Herstellungsverfahren gewählt werden können. Die vorgenannten Vorteile bedeuten nicht zuletzt auch einen deutlichen Kostenvorteil bei der Herstellung des Trägersubstrats und bei der Montage, das heißt bei der vollständigen Einbettung des Bauelements in der Ausnehmung.

Die vorliegende Erfindung betrifft schließlich auch ein Verfahren zum Herstellen einer Vielzahl elektrischer oder elektronischer Bauteile, das durch die im Anspruch 29 angegebenen Merkmale gekennzeichnet ist.

Dieses Verfahren basiert auf einer Platte oder Scheibe ("wafer") eines Trägersubstrats aus halbleitendem oder isolierendem Material, in dem, insbesondere durch (anisotropes) Ätzen, in vorzugsweise gleichmäßigen Abständen eine Vielzahl von Ausnehmungen, insbesondere von Kavitäten oder Vertiefungen, erzeugt wird. Nach Durchlaufen der vorstehend skizzierten Verfahrensschritte, in diesem Falle simultan oder sukzessive für die Vielzahl von Ausnehmungen mit jeweils mindestens einem Bauelement, kann sich erforderlichenfalls ein Testen eines jeden Bauelements sowie ein Beschriften der der Oberfläche des Trägersubstrats entgegengesetzten Fläche des Trägersubstrats insbesondere mittels eines Lasers anschließen; schließlich wird die Vielzahl von zusammenhängend hergestellten Bauteilen vereinzelt, insbesondere durch mechanisches und/oder optisches Zersägen der Platte oder Scheibe.

Ein Ausführungsbeispiel der vorliegenden Erfindung wird nachstehend anhand der Zeichnungen näher erläutert. Es zeigt:
- Fig. 1: ein Ausführungsbeispiel eines elektrischen oder elektronischen Bauteils gemäß der vorliegenden Erfindung, im Querschnitt; und
- Fig. 2: ein Ausführungsbeispiel einer mit einer Vielzahl von Ausnehmungen versehenen Platte oder Scheibe ("wafer") eines Trägersubstrats aus halbleitendem oder isolierendem Material, ebenfalls im Querschnitt.

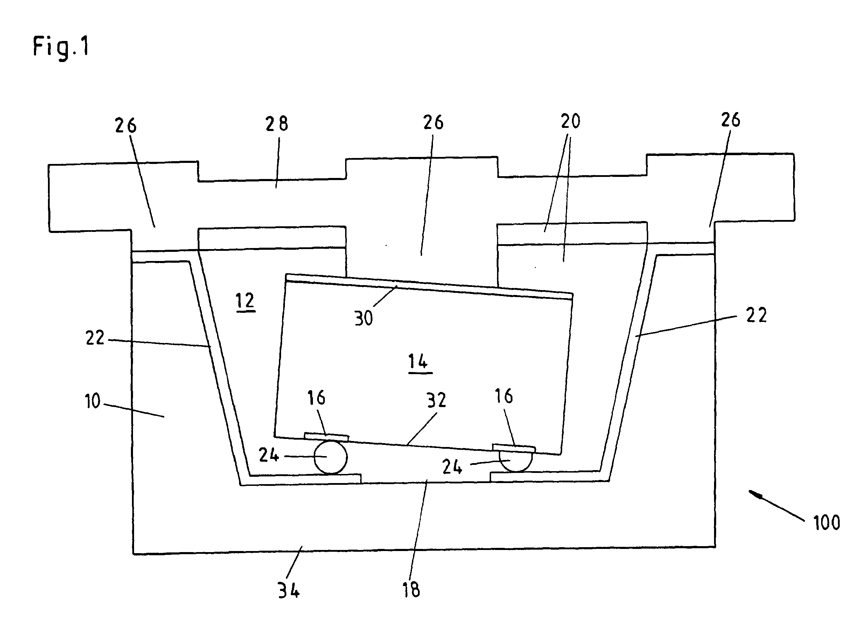

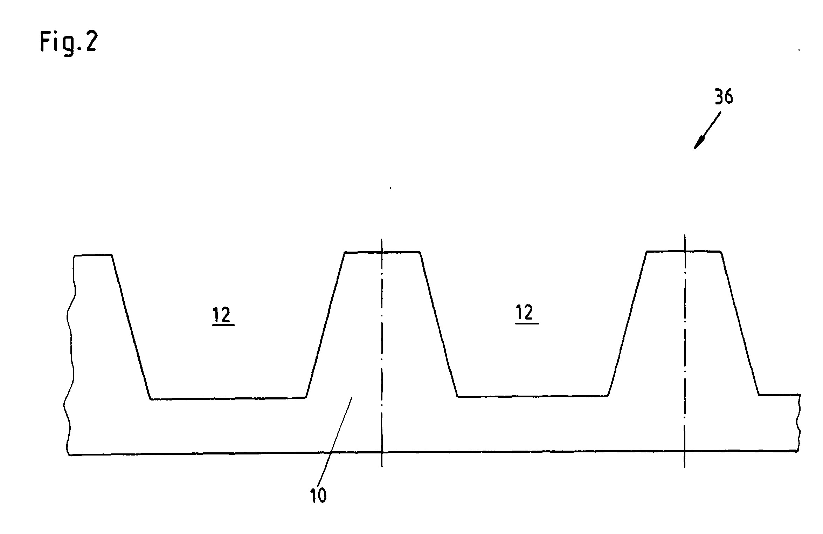

Das in Figur 1 dargestellte elektrische oder elektronische Bauteil 100 ist zum Einsatz auf einer - in den Figuren 1 und 2 aus Gründen der Übersichtlichkeit nicht abgebildeten Leiterplatte (= PCB = printed circuit board) vorgesehen und wird hergestellt, indem zunächst in ein Trägersubstrat 10 aus halbleitendem Material (Silizium) eine im wesentlichen trogförmig ausgebildete Ausnehmung 12 in Form einer Kavität anisotrop geätzt wird. Daraufhin wird auf sich in Figur 1 gegenüberliegenden Seiten der Ausnehmung 12 jeweils eine elektrisch leitende Kontaktbahn 22 lithographisch aufgebracht und zur Erzielung einer höheren elektrischen Leitfähigkeit nachbearbeitet; diese Kontaktbahnen 22 führen vom Bodenbereich 18 der Ausnehmung 12 auf die Oberfläche 28 des Trägersubstrats 10.

Im Anschluss daran wird ein Bauelement 14 in Form eines elektrisch aktiven oder elektronisch aktiven Halbleiterkristalls in der Ausnehmung 12 implantiert; das Bauelement 14 wird hierbei "upside down", das heißt mit seiner Rückseite nach oben in die Ausnehmung 12 eingebettet, so dass die zwei elektrisch leitende Kontaktflächen 16 aufweisende Oberfläche des Bauelements 14 dem Bodenbereich 18 der Ausnehmung 12 zugewandt ist.

Die beiden elektrisch leitenden Kontaktflächcn 16 werden nunmehr im Bodenbereich 18 der Ausnehmung 12 mit den Kontaktbahnen 22 kontaktiert, indem die beiden Kontaktflächen 16 des Bauelements 14 mittels zweier elektrisch leitender, im wesentlichen kugelförmiger Verbindungselemente 24 aus Lot mit dem zugehörigen, sich im Bodenbereich 18 der Ausnehmung 12 befindlichen Abschnitt der jeweiligen Kontaktbahn 22 (= bodenseitiges Ende der jeweiligen Kontaktbahn 22 im Falle der Figur 1) verbunden werden; hierdurch entsteht eine Verlötung der Kontaktfläche 16 des Bauelements 14 mit dem sich im Bodenbereich 18 der Ausnehmung 12 befindlichen Abschnitt der Kontaktbahn 22.

Im Rahmen der Herstellung des in Figur 1 dargestellten elektrischen oder elektronischen Bauteils 100 werden hierbei die Verbindungselemente 24 vor Implantieren des Bauelements 14 im fließfähigen und formbaren Zustand - im speziellen in Form eines aus flüssiger Phase abgeschiedenen Tropfens aus elektrisch leitendem Material - auf die Kontaktfläche 16 des Bauelements 14 aufgebracht, um durch anschließendes Verformen zumindest eines Teils der Verbindungselemente 24 die Position des Bauelements 14 in der Ausnehmung 12 an den Bodenbereich 18 der Ausnehmung 12 und speziell an die Kontaktfläche 16 des Bauelements 14 anzupassen (alternativ hierzu ist es auch möglich, die Verbindungselemente 24 vor Implantieren des Bauelements 14 auf die sich im Bodenbereich 18 der Ausnehmung 12 befindlichen zugeordneten Abschnitte der jeweiligen Kontaktbahn 22 aufzubringen; auch kann jedes der Verbindungselemente 24 vor Implantieren des Bauelements 14 mit Vorteil teilweise auf den sich im Bodenbereich 18 der Ausnehmung 12 befindlichen Abschnitt der Kontaktbahn 22 und teilweise auf die Kontaktfläche 16 des Bauelements 14 aufgebracht werden).

Wie aus Figur 1 ersichtlich ist, ermöglicht die Anordnung der Verbindungselemente 24 mithin eine gewisse Verkippung des in der Ausnehmung 12 implantierten Bauelements 14, ohne dass die elektrische Kontaktierung des Bauelements 14, insbesondere der Kontaktflächen 16, mit dem jeweiligen Abschnitt der zugeordneten Kontaktbahn 22 darunter leiden würde. Hierbei erfolgt, wie ebenfalls Figur 1 entnehmbar ist und wie vorstehend bereits angedeutet wurde, eine Verformung des in Figur 1 rechten der beiden Verbindungselemente 24, wodurch ein Freiheitsgrad hinsichtlich der Position in der Tiefe und Verkippung des Bauelements 14 gewissermaßen "gewonnen" wird.

Um das Bauelement 14 bei seinem späteren Einsatz gegen äußere Einflüsse, insbesondere gegen Beschädigung und gegen Korrosion, zu schützen, wird das in der Ausnehmung 12 implantierte Bauelement 14 vollständig in ein durch eine Umhüllung gebildetes, eigenständiges und geschlossenes Gehäuse ("package") eingeschlossen, indem das Bauelement 14 insbesondere mit den Rändern der Ausnehmung 12 mittels eines Füllmaterials 20 (= SiO₂ = Siliziumdioxid) im wesentlichen eben und koplanar versiegelt wird.

Nach dem Versiegeln werden insgesamt drei zur Erzielung einer höheren elektrischen Leitfähigkeit nachbearbeitete, elektrisch leitende Kontakte 26 auf die versiegelte Oberfläche 28 des Trägersubstrats 10 lithographisch aufgebracht, um eine Kontaktierung des entstandenen elektrischen oder elektronischen Bauteils 100 auf einer Leiterplatte realisieren zu können; in der Praxis wird das elektrische oder elektronische Bauteil 100 dann mit Reflow auf die Leiterplatte gelötet. Hierbei gereicht es dem elektrischen oder elektronischen Bauteil 100 besonders zum Vorteil, dass für die Montage beispielsweise auf einer Leiterplatte keine weitere Umhüllung benötigt wird; vielmehr kann das elektrische oder elektronische Bauteil 100 unmittelbar, das heißt ohne weiteren Adapter oder Träger auf einer Leiterplatte montiert werden.

In diesem Zusammenhang erweist es sich als besonders günstig, dass durch das Herumführen der elektrischen Anschlüsse von den Kontaktflächen 16 des Bauelements 14 über die Verbindungselemente 24 und über die in der Ausnehmung 12 aufgebrachten Kontaktbahnen 22 eben diese elektrischen Anschlüsse samt und sonders auf die Oberfläche 28 des Trägersubstrats 10 geführt werden, auf der sich auch die Lötfläche mit Anschluss an eine Metallisierung auf der "Rückseite", das heißt auf der vom Boden- und/oder Wandbereich 18 der Ausnehmung 12 abgewandten Oberfläche des Bauelements 14 befindet; dies bedeutet mit anderen Worten, dass die elektrischen Anschlüsse sowohl von der Vorderseite des Bauelements 14 als auch von der Rückseite des Bauelements 14 zu einer einzigen Anschlussfläche 28 des Gehäuses ("package") geführt werden.

Zur Realisierung der vorstehend erwähnten "Rückseitenmetallisierung" wird vor Implantieren des Bauelements 14 auf der vom Boden- und/oder Wandbereich 18 der Ausnehmung 12 abgewandten Oberfläche des Bauelements 14 eine elektrisch leitende Kontaktfläche 30 in Form einer Metallisierung aufgebracht. In Verbindung mit den drei auf die versiegelte Oberfläche 28 des Trägersubstrats 10 lithographisch aufgebrachten elektrisch leitenden Kontakten 26 ist demzufolge in erfindungswesentlicher Weise ein elektrisches oder elektronisches Bauteils 100 bereitstellbar, das sich durch elektrisch leitende Kontaktflächen sowohl auf seiner "Vorderseite", das heißt auf der dem Boden- und/oder Wandbereich 18 der Ausnehmung 12 zugewandten Oberfläche des Bauelements 14, als auch auf seiner "Rückseite", das heißt auf der vom Boden- und/oder Wandbereich 18 der Ausnehmung 12 abgewandten Oberfläche des Bauelements 14 auszeichnet. Mit anderen Worten besteht mit der vorliegenden Erfindung die Möglichkeit, Halbleiterkristalle mit Vorderseitenkontakten sowie mit Rückseitenkontakten zu verarbeiten, wodurch das Einsatzspektrum des elektrischen oder elektronischen Bauteils 100 gemäß Figur 1 erheblich erweitert wird.

Um das auf äußere Einwirkungen nicht selten sensibel reagierende Bauelement 14 zusätzlich zu schützen, wird vor Implantieren des Bauelements 14 als ergänzende Maßnahme partiell eine Schutzschicht 32 auf der dem Boden- und/oder Wandbereich 18 der Ausnehmung 12 zugewandten Oberfläche des Bauelements 14 aufgebracht.

Nach Testen des elektrischen oder elektronischen Bauteils 100 kann die der Oberfläche 28 des Trägersubstrats 10 entgegengesetzte Fläche 34 des Trägersubstrats 10 schließlich noch mittels eines Lasers mit bauteilspezifischen Daten (Kenndaten, Seriennummer, ...) beschriftet werden.

Im Ergebnis können bei der vorliegenden Erfindung demzufolge Bauelemente 14 sowohl mit Vorderseitenkontaktierungen als auch mit Rückseitenkontaktierungen eingesetzt werden, so beispielsweise aktive und/oder passive elektronische, optoelektronische, mikromechanische und/oder aktorische Bauelemente aus Festkörpermaterialien mit halbleiter- und/oder mit mikrosystemtechnischen Funktionen, wobei auf Dotierungen der Umhüllung in Form des Trägersubstrats 10 verzichtet werden kann; auch kann durch das Einlegen und Versiegeln des Bauelements 14 in das "Bett" des Trägermaterials 10 und durch das Herausführen der elektrischen Anschlüsse auf das Montieren des Bauelements 14 auf Leadframes sowie auf die damit verbundenen Form-, Plating-, Trim-, Umhüll- und Wirebondprozesse verzichtet werden. Mithin entfallen wesentliche Montageschritte, wodurch die Herstellung der elektrischen oder elektronischen Bauteile 100 einfacher und weniger kostenintensiv wird.

Figur 2 bezieht sich auf ein Verfahren zum Herstellen einer Vielzahl exemplarisch in Figur 1 dargestellter elektrischer oder elektronischer Bauteile 100. Die Besonderheit ist hierbei darin zu erkennen, dass eine Vielzahl von Ausnehmungen 12 ("Taschen") in einer Scheibe 36 ("wafer") eines Trägersubstrats 10 aus halbleitendem Material (Silizium) durch Ätzen erzeugt wird. Hieran schließen sich für jede der Ausnehmungen 12 die vorstehend bereits anhand Figur 1 beschriebenen Verfahrensschritte an, wobei am Ende die Vielzahl der entstandenen elektrischen oder elektronischen Bauteile 100 durch Zersägen der Scheibe 36 entlang der in Figur 2 gestrichelt eingezeichneten Linien vereinzelt wird.

Dieses Herstellungsverfahren zeichnet sich insbesondere dadurch aus, dass es einerseits auf bereits bestehender Wafertechnologie beruht, wodurch die Entwicklungskosten, -risiken und -zeiten geringer als bei einer kompletten technologischen Neuentwicklung sind; andererseits weisen das Material des Bauelements 14 und das Material der Scheibe 36 ähnliche, bei identischem Werkstoff sogar identische thermische Eigenschaften auf, was für die Funktion, für die Lebensdauer und für die Zuverlässigkeit des elektrischen oder elektronischen Bauteils 100 insofern von entscheidendem Vorteil ist, als keine unterschiedlichen Temperaturdehnungen auftreten können und demzufolge eine höhere thermische Belastbarkeit erreicht wird.

### Bezugszeichenliste

- 100: elektrisches oder elektronisches Bauteil
- 10: Trägersubstrat aus halbleitendem oder isolierendem Material
- 12: Ausnehmung, insbesondere Kavität oder Vertiefung
- 14: Bauelement
- 16: elektrisch leitende Kontaktfläche auf der dem Boden- und/oder Wandbereich 18 der Ausnehmung 12 zugewandten Oberfläche des Bauelements 14
- 18: Boden- und/oder Wandbereich
- 20: Füllmaterial
- 22: elektrisch leitende Kontaktbahn
- 24: elektrisch leitendes Verbindungselement
- 26: elektrisch leitender Kontakt
- 28: Oberfläche des Trägersubstrats 10
- 30: elektrisch leitende Kontaktfläche auf der vom Boden- und/oder Wandbereich 18 der Ausnehmung 12 abgewandten Oberfläche des Bauelements 14
- 32: Schutzschicht
- 34: entgegengesetzte Fläche des Trägersubstrats 10
- 36: Platte oder Scheibe ("wafer")

## Patentansprüche

1. Elektrisches oder elektronisches Bauteil (100), aufweisend
ein Trägersubstrat (10) aus halbleitendem oder isolierendem Material;
mindestens eine im Trägersubstrat (10) vorgesehene Ausnehmung (12), insbesondere Kavität oder Vertiefung;
mindestens ein in der Ausnehmung (12) implantiertes Bauelement (14), dessen mindestens eine elektrisch leitende Kontaktfläche (16) aufweisende Oberfläche dem Boden- und/oder Wandbereich (18) der Ausnehmung (12) zugewandt ist und im Boden- und/oder Wandbereich (18) der Ausnehmung (12) kontaktiert ist; und
mindestens ein Füllmaterial (20), mittels dessen das in der Ausnehmung (12) implantierte Bauelement (14) insbesondere mit den Rändern der Ausnehmung (12) versiegelt ist;
mindestens eine vom Boden- und/oder Wandbereich (18) der Ausnehmung (12) auf die Oberfläche (28) des Trägersubstrats (10) führende, elektrisch leitende Kontaktbahn (22) und
mindestens ein zwischen der jeweiligen Kontaktfläche (16) des Bauelements (14) und dem jeweiligen, sich im Boden- und/oder Wandbereich (18) der Ausnehmung (12) befindlichen Abschnitt der Kontaktbahn (22) angeordnetes, elektrisch leitendes Verbindungselement (24), durch das die Kontaktfläche (16) des Bauelements (14) mit dem sich im Boden- und/oder Wandbereich (18) der Ausnehmung (12) befindlichen Abschnitt der Kontaktbahn (22) verbunden ist,
wobei die mindestens eine elektrisch leitende Kontaktbahn (22) ausschließlich auf Boden- und/oder Wandbereich (18) der Ausnehmung (12) und auf der Oberfläche (28) des Trägersubstrats (10) angeordnet ist;
und wobei die mindestens eine elektrisch leitende Kontaktbahn (22) mit je einem auf der Oberfläche (28) des Trägersubstrats (10) aufgebrachten, elektrisch leitenden Kontakt (26) zur Kontaktierung des elektrischen oder elektronischen Bauteils (100) auf einer Leiterplatte verbunden ist;
**dadurch gekennzeichnet, dass**
das Bauelement (14) auf der vom Boden (18) der Ausnehmung (12) abgewandten Oberfläche zumindest partiell mindestens eine elektrisch leitende Kontaktfläche (30) in Form einer Metallisierung aufweist;
sich eine Lötfläche an die mindestens eine, in Form einer Metallisierung ausgeführte, elektrisch leitende Kontaktfläche (30) zur Kontaktierung des elektrischen oder elektronischen Bauteils (100) auf einer Leiterplatte anschließt.

2. Bauteil gemäß Anspruch 1,
**dadurch gekennzeichnet,**
**dass** die Ausnehmung (12) im wesentlichen muldenförmig oder trogförmig oder wannenförmig ausgebildet ist.

3. Bauteil gemäß Anspruch 1 oder 2,
**dadurch gekennzeichnet,**
**dass** das Verbindungselement (24) aus elektrisch leitendem Material, insbesondere aus Lot, ist.

4. Bauteil gemäß mindestens einem der Ansprüche 1 bis 3,
**dadurch gekennzeichnet,**
**dass** das Verbindungselement (24) im wesentlichen hügelförmig oder im wesentlichen kissenförmig oder im wesentlichen kugelförmig ist.

5. Bauteil gemäß mindestens einem der Ansprüche 1 bis 4,
**dadurch gekennzeichnet,**
**dass** das Bauelement (14) mindestens ein IC-Chip (IC = integrated circuit = integrierte Schaltung) und/oder mindestens ein elektrisch aktiver oder elektronisch aktiver (Halbleiter-) Kristall ist.

6. Bauteil gemäß mindestens einem der Ansprüche 1 bis 5,
**dadurch gekennzeichnet,**
**dass** das Füllmaterial (20) zum Versiegeln des in der Ausnehmung (12) implantierten Bauelements (14) Siliziumdioxid (SiO₂) ist.

7. Bauteil gemäß mindestens einem der Ansprüche 1 bis 6,
**dadurch gekennzeichnet,**
**dass** mindestens ein elektrisch leitender Kontakt (26) auf die versiegelte Oberfläche (28) des Trägersubstrats (10) aufgebracht, insbesondere lithographisch aufgebracht, ist.

8. Bauteil gemäß Anspruch 7,
**dadurch gekennzeichnet,**
**dass** der Kontakt (26) nachbearbeitet ist.

9. Bauteil gemäß mindestens einem der Ansprüche 1 bis 8,
**dadurch gekennzeichnet,**
**dass** das Bauelement (14) zumindest partiell mit mindestens einer Schutzschicht (32) versehen ist.

10. Bauteil gemäß Anspruch 9,
**dadurch gekennzeichnet,**
**dass** die Schutzschicht (32) zumindest partiell auf der dem Boden- und/oder Wandbereich (18) der Ausnehmung (12) zugewandten Oberfläche des Bauelements (14) vorgesehen ist.

11. Leiterplatte (= PCB = printed circuit board), aufweisend mindestens ein elektrisches oder elektronisches Bauteil (100) gemäß mindestens einem der Ansprüche 1 bis 10.

12. Verfahren zum Herstellen eines elektrischen oder elektronischen Bauteils (100), aufweisend die folgenden Schritte:
Erzeugen, insbesondere Ätzen, von mindestens einer Ausnehmung (12), insbesondere von mindestens einer Kavität oder Vertiefung, in einem Trägersubstrat (10) aus halbleitendem oder isolierendem Material;
Implantieren von mindestens einem Bauelement (14), insbesondere von mindestens einem IC-Chip und/oder von mindestens einem elektrisch aktiven oder elektronisch aktiven (Halbleiter-)Kristall, in der Ausnehmung (12), wobei die mindestens eine elektrisch leitende Kontaktfläche (16) aufweisende Oberfläche des Bauelements (14) dem Boden- und/oder Wandbereich (18) der Ausnehmung (12) zugewandt ist und im Boden- und/oder Wandbereich (18) der Ausnehmung (12) kontaktiert wird; und
Versiegeln des in der Ausnehmung (12) implantierten Bauelements (14) insbesondere mit den Rändern der Ausnehmung (12) mittels mindestens eines Füllmaterials (20);
wobei vor Implantieren des Bauelements (14) mindestens eine vom Boden- und/oder Wandbereich (18) der Ausnehmung (12) auf die Oberfläche (28) des Trägersubstrats (10) führende, elektrisch leitende Kontaktbahn (22) aufgebracht, insbesondere lithographisch aufgebracht, wird, die ausschließlich auf Boden- und/oder Wandbereich (18) der Ausnehmung (12) und auf der Oberfläche (28) des Trägersubstrats (10) angeordnet ist; und
wobei mindestens ein, insbesondere zwei oder mehr elektrisch leitende Verbindungselemente (24) angeordnet werden, durch die die mindestens eine, insbesondere zwei oder mehr Kontaktflächen (16) des Bauelements (14) mit dem jeweiligen, sich im Boden- und/oder Wandbereich (18) der Ausnehmung (12) befindlichen Abschnitt der mindestens einen, insbesondere zwei oder mehr Kontaktbahnen (22) verbunden werden
die mindestens eine elektrisch leitende Kontaktbahn (22) mit je einem auf der Oberfläche (28) des Trägersubstrats (10) aufgebrachten, elektrisch leitenden Kontakt (26) zur Kontaktierung des elektrischen oder elektronischen Bauteils (100) auf einer Leiterplatte verbunden ist;
**dadurch gekennzeichnet dass**,
das Bauelement (14) auf der vom Boden (18) der Ausnehmung (12) abgewandten Oberfläche zumindest partiell mindestens eine elektrisch leitende Kontaktfläche (30) in Form einer Metallisierung aufweist;
sich eine Lötfläche an die mindestens eine, in Form einer Metallisierung ausgeführte, elektrisch leitende Kontaktfläche (30) zur Kontaktierung des elektrischen oder elektronischen Bauteils (100) auf einer Leiterplatte anschließt.

13. Verfahren gemäß Anspruch 12,
**dadurch gekennzeichnet,**
**dass** das Verbindungselement (24) vor Implantieren des Bauelements (14) im fließfähigen und/oder formbaren Zustand angeordnet wird, um durch Verformen des Verbindungselements (24) die Position des Bauelements (14) in der Ausnehmung (12) an den Boden- und/oder Wandbereich (18) der Ausnehmung (12) und/oder an die Kontaktfläche (16) des Bauelements (14) anzupassen.

14. Verfahren gemäß Anspruch 12 oder 13,
**dadurch gekennzeichnet,**
**dass** das Verbindungselement (24) vor Implantieren des Bauelements (14) auf den sich im Boden- und/oder Wandbereich (18) der Ausnehmung (12) befindlichen Abschnitt der Kontaktbahn (22) aufgebracht wird.

15. Verfahren gemäß mindestens einem der Ansprüche 12 bis 14,
**dadurch gekennzeichnet,**
**dass** das Verbindungselement (24) vor Implantieren des Bauelements (14) auf die Kontaktfläche (16) des Bauelements (14) aufgebracht wird.

16. Verfahren gemäß mindestens einem der Ansprüche 12 bis 15,
**dadurch gekennzeichnet,**
**dass** das Verbindungselement (24) vor Implantieren des Bauelements (14) teilweise auf den sich im Boden- und/oder Wandbereich (18) der Ausnehmung (12) befindlichen Abschnitt der Kontaktbahn (22) und teilweise auf die Kontaktfläche (16) des Bauelements (14) aufgebracht wird.

17. Verfahren gemäß mindestens einem der Ansprüche 12 bis 16,
**dadurch gekennzeichnet,**
**dass** das Verbindungselement (24) vor Implantieren des Bauelements (14) aufgebracht wird, indem elektrisch leitendes Material insbesondere aus flüssiger Phase (beispielsweise Pilzgalvanik) oder insbesondere aus gasförmiger Phase abgeschieden wird.

18. Verfahren gemäß mindestens einem der Ansprüche 12 bis 17,
**dadurch gekennzeichnet,**
**dass** das Verbindungselement (24) vor Implantieren des Bauelements (14) in Form mindestens eines Tropfens aus elektrisch leitendem Material aufgebracht wird, insbesondere durch Anschmelzen mindestens eines Metalldrahts.

19. Verfahren gemäß mindestens einem der Ansprüche 12 bis 18,
**dadurch gekennzeichnet,**
**dass** der sich im Boden- und/oder Wandbereich (18) der Ausnehmung (12) befindliche Abschnitt der Kontaktbahn (22) und die Kontaktfläche (16) des Bauelements (14) durch das Verbindungselement (24) miteinander verlötet werden.

20. Verfahren gemäß mindestens einem der Ansprüche 12 bis 19,
**dadurch gekennzeichnet,**
**dass** die Kontaktbahn (22) nachbearbeitet wird.

21. Verfahren gemäß mindestens einem der Ansprüche 12 bis 20,
**dadurch gekennzeichnet,**
**dass** nach dem Versiegeln mindestens ein elektrisch leitender Kontakt (26) auf die versiegelte Oberfläche (28) des Trägersubstrats (10) aufgebracht, insbesondere lithographisch aufgebracht, wird.

22. Verfahren gemäß Anspruch 21,
**dadurch gekennzeichnet,**
**dass** der Kontakt (26) nachbearbeitet wird.

23. Verfahren gemäß mindestens einem der Ansprüche 12 bis 22,
**dadurch gekennzeichnet,**
**dass** die mindestens eine elektrisch leitende Kontaktfläche (30) in Form einer Metallisierung vor Implantieren des Bauelements (14) zumindest partiell auf der vom Boden der Ausnehmung (12) abgewandten Oberfläche des Bauelements (14) aufgebracht wird.

24. Verfahren gemäß mindestens einem der Ansprüche 12 bis 23,
**dadurch gekennzeichnet,**
**dass** vor Implantieren des Bauelements (14) zumindest partiell mindestens eine Schutzschicht (32) auf das Bauelement (14) aufgebracht wird.

25. Verfahren gemäß Anspruch 24,
**dadurch gekennzeichnet,**
**dass** die Schutzschicht (32) zumindest partiell auf der dem Boden- und/oder Wandbereich (18) der Ausnehmung (12) zugewandten Oberfläche des Bauelements (14) aufgebracht wird.

26. Verfahren gemäß mindestens einem der Ansprüche 12 bis 25,
**dadurch gekennzeichnet,**
**dass** nach dem Versiegeln und gegebenenfalls nach Testen des Bauelements (14) die der Oberfläche (28) des Trägersubstrats (10) entgegengesetzte Fläche (34) des Trägersubstrats (10) insbesondere mittels eines Lasers beschriftet wird.

27. Verfahren zum Herstellen einer Vielzahl elektrischer oder elektronischer Bauteile (100), gemäß mindestens einem der Ansprüche 12 bis 26, **gekennzeichnet durch** die folgenden Schritte:
Erzeugen, insbesondere Ätzen, einer Vielzahl von besagten Ausnehmungen (12), insbesondere Kavitäten oder Vertiefungen, in einer Platte oder Scheibe (36; "wafer") besagten Trägersubstrats (10) aus halbleitendem oder isolierendem Material;
Aufbringen, insbesondere lithographisches Aufbringen, von jeweils mindestens einer besagter vom Boden- und/oder Wandbereich (18) einer jeden Ausnehmung (12) auf die der jeweiligen Ausnehmung (12) zugeordnete Oberfläche (28) des Trägersubstrats (10) führenden, elektrisch leitenden Kontaktbahn (22);
Anordnen von jeweils mindestens einem, insbesondere zwei oder mehr besagten elektrisch leitenden Verbindungselementen (24) zum Verbinden von jeweils mindestens einer, insbesondere zwei oder mehr sich auf der Oberfläche eines Bauelements (14), insbesondere eines IC-Chips und/oder eines elektrisch aktiven oder elektronisch aktiven (Halbleiter-)Kristalls, befindlichen elektrisch leitenden Kontaktflächen (16) mit dem jeweiligen, sich im Boden- und/oder Wandbereich (18) der Ausnehmung (12) befindlichen Abschnitt der mindestens einen, insbesondere zwei oder mehr Kontaktbahnen (22);
Implantieren von jeweils mindestens einem der besagten Bauelemente (14) in jeder der besagten Ausnehmungen (12), wobei die die Kontaktfläche (16) aufweisende Oberfläche des jeweiligen Bauelements (14) dem Boden- und/oder Wandbereich (18) der jeweiligen Ausnehmung (12) zugewandt ist und im Boden- und/oder Wandbereich (18) der Ausnehmung (12) kontaktiert wird;
Versiegeln der in den Ausnehmungen (12) implantierten Bauelemente (14) insbesondere mit den Rändern der Ausnehmungen (12) mittels mindestens eines Füllmaterials (20); und
Vereinzeln der Vielzahl von Bauteilen (100), insbesondere **durch** mechanisches und/oder optisches Zersägen der Platte oder Scheibe (36).

## Claims

1. An electric or electronic component (100) comprising a carrier substrate (10) of a semiconducting or insulating material;
at least a recess (12), particularly a cavity or indentation provided in the carrier substrate (10);
at least a component (14) which is inserted into the recess (12) and whose surface having at least one electrically conducting contact face (16) faces the bottom and/or wall area (18) of the recess (12) and is contacted in the bottom and/or wall area (18) of the recess (12); and
at least a filling material (20) by means of which the component (14) inserted into the recess (12) is sealed particularly with the edges of the recess (12);
at least one electrically conducting contact track (22) extending from the bottom and/or wall area (18) of the recess (12) to the surface (28) of the carrier substrate (10); and
at least one electrically conducting connection element (24) is arranged between the respective contact face (16) of the component (14) and the respective section of the contact track (22) present in the bottom and/or wall area (18) of the recess (12), by which connection element the contact face (16) of the component (14) is connected to the section of the contact track (22) present in the bottom and/or wall area (18) of the recess (12),
where at least one electrically conducting contact track (22) is provided on the bottom and/or wall area (18) of the recess (12) and on the surface (28) of the carrier substrate (10);
and where the at least one electrically conducting contact track (22) is connected to a respective electrically conducting contact (26) provided on the surface (28) of the carrier substrate (10) so as to contact the electric or electronic component (100) on a printed circuit board;
**characterized in that** the component (14) at least partially has on the surface facing away from the bottom (18) of the recess (12) at least one electrically conducting contact face (30) in the form of a metallization;
a soldering face has a connection to the at least one contact face (30) arranged in the form of a metallization so as to contact the electric or electronic component (100) on a printed circuit board.

2. A component as claimed in claim 1, **characterized in that** the recess (12) is essentially formed as a groove, trough or tub.

3. A component as claimed in claim 1 or 2, **characterized in that** the connection element (24) is made of an electrically conducting material, particularly lead.

4. A component as claimed in any one of claims 1 to 3, **characterized in that** the connection element (24) is essentially hill-shaped or essentially pillow-shaped or essentially ball-shaped.

5. A component as claimed in any one of claims 1 to 4, **characterized in that** the component (14) is at least one IC chip and/or at least one electrically active or electronically active (semiconductor) crystal.

6. A component as claimed in any one of claims 1 to 5, **characterized in that** the filling material (20) for sealing the component (14) inserted into the recess (12) is silicon dioxide (SiO₂).

7. A component as claimed in any one of claims 1 to 6, **characterized in that** at least one electrically conducting contact (26) is provided, particularly lithographically, on the sealed surface (28) of the carrier substrate (10).

8. A component as claimed in claim 7, **characterized in that** the contact (26) is machine-finished.

9. A component as claimed in any one of claims 1 to 8, **characterized in that** the component (14) is at least partially provided with at least a protective coating (32).

10. A component as claimed in claim 9, **characterized in that** the protective coating (32) is at least partially provided on the surface of the component (14) facing the bottom and/or wall area (18) of the recess (12).

11. A printed circuit board comprising at least one electric or electronic component (100) as claimed in any one of claims 1 to 10.

12. A method of manufacturing an electric or electronic component (100), the method comprising the steps of:
generating, particularly etching, at least a recess (12) particularly at least a cavity or indentation, in a carrier substrate (10) of a semiconducting or insulating material;
inserting at least a component (14), particularly at least an IC chip and/or at least one electrically active or electronically active (semiconductor) crystal, into the recess (12), in which the surface of the component (14) having at least one electrically conducting contact face (16) faces the bottom and/or wall area (18) of the recess (12) and is contacted in the bottom and/or wall area (18) of the recess (12);, and
sealing the component (14) inserted into the recess (12), particularly with the edges of the recess (12), by means of at least a filling material (20),
where, prior to the insertion of the component (14), at least one electrically conducting contact track (22) extending from the bottom and/or wall area (18) of the recess (12) to the surface (28) of the carrier substrate (10) is provided, particularly lithographically, which is exclusively provided on the bottom and/or wall area (18) of the recess (12) and on the surface (28) of the carrier substrate (10); and
where at least one, particularly two or more electrically conducting connection elements (24) are arranged, by which the at least one, particularly two or more contact faces (16) of the component (14) are connected to the respective section, present in the bottom and/or wall area (18) of the recess (12), of the at least one, particularly two or more contact tracks (22); the at least one electrically conducting contact track (22) is connected to an electrically conducting contact (26) provided on the surface (28) of the carrier substrate (10) so as to realize contact of the electric or electronic component (100) on a printed circuit board; **characterized in that** the component (14) on the surface turned away from the bottom (18) of the recess (12) has at least partially at least one electrically conducting contact face (30) in the form of a metallization; and
a soldering face is connected to the at least one electrically conducting contact face (30) as a metallization so as to realize contact of the electric or electronic component (100) on a printed circuit board.

13. A method as claimed in claim 12, **characterized in that**, prior to the insertion of the component (14), the connection element (24) is arranged in a fluid and/or moldable state so as to adapt the position of the component (14) in the recess (12) to the bottom and/or wall area (18) of the recess (12) and/or to the contact face (16) of the component (14) by way of deformation of the connection element (24).

14. A method as claimed in claim 12 or 13, **characterized in that**, prior to the insertion of the component (14), the connection element (24) is provided on the section of the contact track (22) present in the bottom and/or wall area (18) of the recess (12).

15. A method as claimed in any one of claims 12 to 14, **characterized in that**, prior to the insertion of the component (14), the connection element (24) is provided on the contact face (16) of the component (14).

16. A method as claimed in any one of claims 12 to 15, **characterized in that**, prior to the insertion of the component (14), the connection element (24) is partly provided on the section of the contact track (22) present in the bottom and/or wall area (18) of the recess (12) and is partly provided on the contact face (16) of the component (14).

17. A method as claimed in any one of claims 12 to 16, **characterized in that**, prior to the insertion of the component (14), the connection element (24) is provided by depositing electrically conducting material particularly from a liquid phase (for example, galvanic growth) or particularly from a gaseous phase.

18. A method as claimed in any one of claims 12 to 17, **characterized in that**, prior to the insertion of the component (14), the connection element (24) is provided in the form of at least a drop of electrically conducting material, particularly by sealing with at least a metal wire.

19. A method as claimed in any one of claims 12 to 18, **characterized in that** the section of the contact track (22) present in the bottom and/or wall area (18) of the recess (12) and the contact face (16) of the component (14) are soldered together by means of the connection element (24).

20. A method as claimed in any one of claims 12 to 19, **characterized in that** the contact track (22) is machine-finished.

21. A method as claimed in any one of claims 12 to 20, **characterized in that**, after sealing, at least one electrically conducting contact (26) is provided, particularly lithographically, on the sealed surface (28) of the carrier substrate (10).

22. A method as claimed in claim 21, **characterized in that** the contact (26) is machine-finished.

23. A method as claimed in any one of claims 12 to 22, **characterized in that**, prior to the insertion of the component (14), the at least one electrically conducting contact face (30), in the form of a metallization, is at least partially provided on the component surface (14) facing away from the bottom of the recess (12).

24. A method as claimed in any one of claims 12 to 23, **characterized in that**, prior to the insertion of the component (14), at least a protective coating (32) is at least partially provided on the component (14).

25. A method as claimed in claim 24, **characterized in that** the protective coating (32) is provided at least partially on the surface of the component (14) facing the bottom and/or wall area (18) of the recess (12).

26. A method as claimed in any one of claims 12 to 25, **characterized in that**, after sealing and possibly testing the component (14), the surface (34) of the carrier substrate (10) opposite the surface (28) of the carrier substrate (10) is printed, particularly by means of a laser.

27. A method of manufacturing a multitude of electric or electronic components (100), as claimed in any one of claims 12 to 26, **characterized by** the steps of:
generating, particularly etching, a multitude of said recesses (12), particularly cavities or indentations, in a wafer (36) of said carrier substrate (10) of a semiconducting or insulating material;
providing, particularly lithographically providing, at least said one electrically conducting contact track (22) extending from the bottom and/or wall area (18) of a recess (12) to the surface (28) of the carrier substrate (10) associated with the relevant recess (12);
arranging at least one, particularly two or more said electrically conducting connection elements (24) for connecting at least one, particularly two or more electrically conducting contact faces (16) present on the surface of a component (14), particularly of an IC chip and/or an electrically active or electronically active (semiconductor) crystal on the respective section, present in the bottom and/or wall area (18) of the recess (12), of the at least one, particularly two or more contact tracks (22);
inserting at least one of said components (14) into each of said recesses (12), in which the surface of the respective component (14) having the contact face (16) faces the bottom and/or wall area (18) of the respective recess (12) and is contacted in the bottom and/or wall area (18) of the recess (12);
sealing the components (14), inserted into the recesses (12), particularly with the edges of the recesses (12) by means of at least a filling material (20); and splitting the multitude of components (100) into individual pieces, particularly by mechanical and/or optical sawing of the wafer (36).

## Revendications

1. Composant électrique ou électronique (100) présentant
un substrat porteur (10) constitué d'un matériau semi-conducteur ou isolant ;
au moins un évidement (12) prévu dans le substrat porteur (10), notamment une cavité ou un renfoncement ;
au moins un élément de montage (14) implanté dans l'évidement (12), dont la surface présentant au moins une face de contact (16) conductrice électriquement est tournée vers la zone de fond et/ou de paroi (18) de l'évidement (12) et est mise en contact dans la zone de fond et/ou de paroi (18) de l'évidement (12) ; et
au moins un matériau de remplissage (20), au moyen duquel l'élément de montage (14) implanté dans l'évidement (12) est scellé notamment avec les bords de l'évidement (12) ;
au moins une piste de contact (22) conductrice électriquement menant de la zone de fond et/ou de paroi (18) de l'évidement (12) sur la surface (28) du substrat porteur (10) et
au moins un élément de liaison (24) conducteur électriquement, agencé entre la face de contact (16) respective de l'élément de montage (14) et le tronçon respectif de la piste de contact (22) se trouvant dans la zone de fond et/ou de paroi (18) de l'évidement (12), à travers lequel la face de contact (16) de l'élément de montage (14) est reliée au tronçon de la piste de contact (22) se trouvant dans la zone de fond et/ou de paroi (18) de l'évidement (12),
la au moins une piste de contact (22) conductrice électriquement étant agencée exclusivement sur la zone de fond et/ou de paroi (18) de l'évidement (12) et sur la surface (28) du substrat porteur (10) ;
et la au moins une piste de contact (22) conductrice électriquement étant reliée à respectivement un contact (26) conducteur électriquement, appliqué sur la surface (28) du substrat porteur (10), permettant la mise en contact du composant électrique ou électronique (100) sur une carte de circuit imprimé ;
**caractérisé en ce que** au moins partiellement, l'élément de montage (14) présente sur la surface opposée au fond (18) de l'évidement (12) au moins une face de contact (30) conductrice électriquement sous forme de revêtement métallique ;
une surface de brasage étant reliée à la au moins une face de contact (30) conductrice électriquement, réalisée sous forme de revêtement métallique, permettant la mise en contact du composant électrique ou électronique (100) sur une carte de circuit imprimé.

2. Composant selon la revendication 1,
**caractérisé en ce**
**que** l'évidement (12) est réalisé essentiellement en forme d'auge ou de bac ou de bassine.

3. Composant selon la revendication 1 ou 2,
**caractérisé en ce**
**que** l'élément de liaison (24) est constitué d'un matériau conducteur électriquement, notamment du plomb.

4. Composant selon au moins l'une quelconque des revendications 1 à 3,
**caractérisé en ce**
**que** l'élément de liaison (24) présente essentiellement la forme d'un monticule ou essentiellement la forme d'un coussin ou essentiellement la forme d'une sphère.

5. Composant selon au moins l'une quelconque des revendications 1 à 4,
**caractérisé en ce**
**que** l'élément de montage (14) est au moins une puce de CI (CI = circuit intégré = IC = integrated circuit) et/ou au moins un cristal (semi-conducteur) actif électriquement ou actif électroniquement.

6. Composant selon au moins l'une quelconque des revendications 1 à 5,
**caractérisé en ce**
**que** le matériau de remplissage (20) permettant de sceller l'élément de montage (14) implanté dans l'évidement (12) est du dioxyde de silicium (SiO₂).

7. Composant selon au moins l'une quelconque des revendications 1 à 6,
**caractérisé en ce**
**qu'**au moins un contact (26) conducteur électriquement est appliqué sur la surface scellée (28) du substrat porteur (10), notamment par lithographie.

8. Composant selon la revendication 7,
**caractérisé en ce**
**que** le contact (26) est usiné.

9. Composant selon au moins l'une quelconque des revendications 1 à 8,
**caractérisé en ce**
**qu'**au moins partiellement, l'élément de montage (14) est pourvu d'au moins une couche de protection (32).

10. Composant selon la revendication 9,
**caractérisé en ce**
**qu'**au moins partiellement, la couche de protection (32) est prévue sur la surface de l'élément de montage (14) tournée vers la zone de fond et/ou de paroi (18) de l'évidement (12).

11. Carte de circuit imprimé (PCB = printed circuit board) présentant au moins un composant électrique ou électronique (100) selon au moins l'une quelconque des revendications 1 à 10.

12. Procédé de fabrication d'un composant électrique ou électronique (100), présentant les étapes consistant à :
fabriquer, notamment graver, au moins un évidement (12), en particulier au moins une cavité ou un renfoncement, dans un substrat porteur (10) constitué d'un matériau semi-conducteur ou isolant ;
implanter au moins un élément de montage (14), notamment au moins une puce de circuit intégré et/ou au moins un cristal (semi-conducteur) actif électriquement ou actif électroniquement, dans l'évidement (12), la surface de l'élément de montage (14) présentant au moins une face de contact (16) conductrice électriquement étant tournée vers la zone de fond et/ou de paroi (18) de l'évidement (12) et étant mise en contact dans la zone de fond et/ou de paroi (18) de l'évidement (12) ; et
sceller l'élément de montage (14) implanté dans l'évidement (12) notamment avec les bords de l'évidement (12) au moyen d'au moins un matériau de remplissage (20) ; de manière que, avant d'implanter l'élément de montage (14), au moins une piste de contact (22) conductrice électriquement, menant de la zone de fond et/ou de paroi (18) de l'évidement (12) sur la surface (28) du substrat porteur (10), étant appliquée, notamment par lithographie, laquelle piste de contact est agencée exclusivement sur la zone de fond et/ou de paroi (18) de l'évidement (12) et sur la surface (28) du substrat porteur (10) ; et
des éléments de liaison (24) conducteurs électriquement au moins au nombre de un, notamment au nombre de deux ou plus, étant agencés, à travers lesquels les faces de contact (16) de l'élément de montage (14) au moins au nombre de un, notamment au nombre de deux ou plus, sont reliées au tronçon respectif des pistes de contact (22) au moins au nombre de un, notamment au nombre de deux ou plus, se trouvant dans la zone de fond et/ou de paroi (18) de l'évidement (12)
la au moins une piste de contact (22) conductrice électriquement étant reliée à respectivement un contact (26) conducteur électriquement, appliqué sur la surface (28) du substrat porteur (10), permettant la mise en contact du composant électrique ou électronique (100) sur une carte de circuit imprimé ;
**caractérisé en ce que**
au moins partiellement, l'élément de montage (14) présente sur la surface opposée au fond (18) de l'évidement (12) au moins une face de contact (30) conductrice électriquement sous forme de revêtement métallique ;
une surface de brasage étant reliée à la au moins une face de contact (30) conductrice électriquement, réalisée sous forme de revêtement métallique, permettant la mise en contact du composant électrique ou électronique (100) sur une carte de circuit imprimé.

13. Procédé selon la revendication 12,
**caractérisé en ce que**
avant d'implanter l'élément de montage (14), l'élément de liaison (24) est agencé dans un état coulant et/ou malléable, afin d'adapter la position de l'élément de montage (14) dans l'évidement (12) au niveau de la zone de fond et/ou de paroi (18) de l'évidement (12) et/ou au niveau de la face de contact (16) de l'élément de montage (14) par la déformation de l'élément de liaison (24).

14. Procédé selon la revendication 12 ou 13,
**caractérisé en ce que**
avant d'implanter l'élément de montage (14), l'élément de liaison (24) est appliqué sur le tronçon de la piste de contact (22) se trouvant dans la zone de fond et/ou de paroi (18) de l'évidement (12).

15. Procédé selon au moins l'une quelconque des revendications 12 à 14,
**caractérisé en ce que**
avant d'implanter l'élément de montage (14), l'élément de liaison (24) est appliqué sur la face de contact (16) de l'élément de montage (14).

16. Procédé selon au moins l'une quelconque des revendications 12 à 15,
**caractérisé en ce que**
avant d'implanter l'élément de montage (14), l'élément de liaison (24) est appliqué en partie sur le tronçon de la piste de contact (22) se trouvant dans la zone de fond et/ou de paroi (18) de l'évidement (12) et en partie sur la face de contact (16) de l'élément de montage (14).

17. Procédé selon au moins l'une quelconque des revendications 12 à 16,
**caractérisé en ce que**
avant d'implanter l'élément de montage (14), l'élément de liaison (24) est appliqué en déposant le matériau conducteur électriquement notamment à partir de la phase liquide (par exemple par galvanoplastie) ou notamment à partir de la phase gazeuse.

18. Procédé selon au moins l'une quelconque des revendications 12 à 17,
**caractérisé en ce que**
avant d'implanter l'élément de montage (14), l'élément de liaison (24) est appliqué sous la forme d'au moins une goutte de matériau conducteur électriquement, notamment par la fusion d'au moins un fil métallique.

19. Procédé selon au moins l'une quelconque des revendications 12 à 18,
**caractérisé en ce que**
le tronçon de la piste de contact (22) se trouvant dans la zone de fond et/ou de paroi (18) de l'évidement (12) et la face de contact (16) de l'élément de montage (14) sont soudés ensemble par le biais de l'élément de liaison (24).

20. Procédé selon au moins l'une quelconque des revendications 12 à 19,
**caractérisé en ce que**
la piste de contact (22) est usinée.

21. Procédé selon au moins l'une quelconque des revendications 12 à 20,
**caractérisé en ce que**
après le scellage, au moins un contact (26) conducteur électriquement est appliqué sur la surface scellée (28) du substrat porteur (10), notamment par lithographie.

22. Procédé selon la revendication 21,
**caractérisé en ce que**
le contact (26) est usiné.

23. Procédé selon au moins l'une quelconque des revendications 12 à 22,
**caractérisé en ce que**
avant d'implanter l'élément de montage (14), la au moins une face de contact (30) conductrice électriquement sous forme d'un revêtement métallique est appliquée au moins partiellement sur la surface de l'élément de montage (14) opposée au fond de l'évidement (12).

24. Procédé selon au moins l'une quelconque des revendications 12 à 23,
**caractérisé en ce que**
avant d'implanter l'élément de montage (14), au moins une couche de protection (32) est appliquée au moins partiellement sur l'élément de montage (14).

25. Procédé selon la revendication 24,
**caractérisé en ce que**
la couche de protection (32) est appliquée au moins partiellement sur la surface de l'élément de montage (14) tournée vers la zone de fond et/ou de paroi (18) de l'évidement (12).

26. Procédé selon au moins l'une quelconque des revendications 12 à 25,
**caractérisé en ce que**
après avoir scellé et, le cas échéant, testé l'élément de montage (14), une inscription est apposée sur la face (34) du substrat porteur (10) opposée à la surface (28) du substrat porteur (10), notamment au moyen d'un laser.

27. Procédé de fabrication d'une pluralité de composants électriques ou électroniques (100) selon au moins l'une quelconque des revendications 12 à 26, **caractérisé par** les étapes suivantes consistant à :
fabriquer, notamment graver, une pluralité d'évidements (12) susmentionnés, en particulier des cavités ou des renfoncements, dans une plaque ou une tranche (36 ; « wafer ») du substrat porteur (10) susmentionné constitué d'un matériau semi-conducteur ou isolant ;
appliquer, notamment par lithographie, respectivement au moins une piste de contact (22) conductrice électriquement susmentionnée, menant de la zone de fond et/ou de paroi (18) de chaque évidement (12) sur la surface (28) du substrat porteur (10) associée à l'évidement (12) respectif ;
agencer respectivement des éléments de liaison (24) conducteurs électriquement susmentionnés au moins au nombre de un, notamment au nombre de deux ou plus, pour relier respectivement des faces de contact (16) conductrices électriquement au moins au nombre de un, notamment au nombre de deux ou plus, se trouvant sur la surface d'un élément de montage (14), en particulier d'une puce de circuit intégré et/ou d'un cristal (semi-conducteur) actif électriquement ou actif électroniquement, avec le tronçon respectif des pistes de contact (22) au moins au nombre de un, notamment au nombre de deux ou plus, se trouvant dans la zone de fond et/ou de paroi (18) de l'évidement (12) ;
implanter respectivement au moins l'un des éléments de montage (14) susmentionnés dans chacun des évidements (12) susmentionnés, la surface de l'élément de montage (14) respectif présentant la face de contact (16) étant tournée vers la zone de fond et/ou de paroi (18) de l'évidement (12) respectif et étant mise en contact dans la zone de fond et/ou de paroi (18) de l'évidement (12) ;
sceller les éléments de montage (14) implantés dans les évidements (12) notamment avec les bords des évidements (12) au moyen d'au moins un matériau de remplissage (20) ; et
séparer la pluralité de composants (100), en particulier par un sciage mécanique et/ou optique de la plaque ou de la tranche (36).
